Europäisches Patentamt

European Patent Office

Office européen des brevets

(19)

(11) **EP 0 776 480 B1**

(12) **EUROPEAN PATENT SPECIFICATION**

(45) Date of publication and mention
of the grant of the patent:
**19.01.2000 Bulletin 2000/03**

(51) Int Cl.⁷: **G01R 27/26**

(86) International application number:
**PCT/CA95/00486**

(21) Application number: **95928908.3**

(22) Date of filing: **21.08.1995**

(87) International publication number:
**WO 96/06361 (29.02.1996 Gazette 1996/10)**

(54) **CAPACITIVE MEASURING DEVICE WITH MOSFET**

KAPAZITIVE MESSANORDNUNG MIT EINEM MOS-FET

DISPOSITIF DE MESURE CAPACITIVE DOTE D'UN MOSFET

(84) Designated Contracting States:
**DE FR GB IT SE**

(30) Priority: **22.08.1994 US 294602**

(43) Date of publication of application:
**04.06.1997 Bulletin 1997/23**

(73) Proprietor: **MITEL CORPORATION
Kanata Ontario K2K 1X3 (CA)**

(72) Inventor: **MANKU, Tajinder
Waterloo, Ontario N2L3G1 (CA)**

(74) Representative: **Copp, David Christopher
Dummett Copp,
25 The Square,
Martlesham Heath
Ipswich, Suffolk IP5 7SL (GB)**

(56) References cited:
**DD-A- 154 507          US-A- 5 212 454**

**Description**

This invention relates to a capacitance measuring circuit and a method of measuring capacitance.

Presently most practical methods of measuring capacitance require an AC input and output signal. For example, US patent no. 5,212,454 describes an arrangement wherein a high frequency voltage signal is applied to a capacitor and the resulting current measured.

East German patent no. 0 154 507 discloses a capacitance measuring circuit employing two capacitors and a MOS transistor with a source, drain, and gate.

An object of the invention is to provide a method and circuit for measuring capacitance that avoids the need to apply an AC input.

Accordingly the invention provides a capacitance measuring circuit comprising a MOS transistor having a source, drain, and gate; a first capacitor C and a second capacitor $C_x$, characterized in that said first capacitor C is connected across said gate and said drain so that charge is coupled from said drain onto said gate, said second capacitor $C_x$ is connected to a source of variable gate voltage $V_G$ and said gate, one of said first and second capacitors having a known capacitance and the other of said first and second capacitors having an unknown capacitance which is to be measured, means for applying a saturation current between said source and drain; and means for measuring the ratio $\delta V_G / \delta V_d$ at said saturation current, where $V_G$ is the applied gate voltage, and $V_d$ is the measured drain voltage, to derive said unknown capacitance from said ratio in accordance with the relationship:

$$\frac{C}{C_x} = -\left.\frac{\partial V_G}{\partial V_d}\right|_{Ids-sat}$$

where the right hand side of the relationship is the ratio of $-\delta V_G / \delta V_d$ at said saturation current.

In the preferred embodiment, the MOS transistor is an n-channel MOSFET.

The invention makes use of the fact that in an arrangement where the gate is isolated from the gate voltage by a capacitor $C_x$, and charge is coupled from the drain to the gate by another capacitor C, the amount of charge that is coupled is determined by the ratio $C/C_x$, or in other words

$$\frac{C}{C_x} = -\left.\frac{\partial V_G}{\partial V_d}\right|_{Ids-sat}$$

The invention thus allows capacitance to be measured using D.C. alone. The circuit can be integrated on a chip using either CMOS, BICMOS, NMOS, or any technology that can fabricate MOS devices.

The key aspect of this invention is that it can measure the capacitance using only D.C. measurements.

In a further aspect the invention provides a capacitance measuring circuit comprising a MOS transistor having a source, drain, and gate; a first capacitor C and a second capacitor $C_{x1}$, characterized in that said second capacitor $C_{x1}$ has a first terminal connected to said gate and a second terminal connected to one terminal of a third capacitor $C_{x2}$ whose other terminal is connected to a source of variable gate voltage $V_G$, one of said capacitors being known, said first capacitor C has a first terminal connected to said drain and a second terminal connected to switch means for selectively connecting said second terminal of said first capacitor C to said gate or the second terminal of said second capacitor $C_{x1}$ so that charge is coupled from said drain onto said gate either through said first capacitor C and said second capacitor $C_{x1}$, or through said first capacitor C alone; means for applying a saturation current between said source and drain; and means for measuring the ratio $\delta V_G / \delta V_d$ at said saturation current, where $V_G$ is the applied gate voltage, and $V_d$ is the measured drain voltage, for each condition of said switch means to derive the capacitance of said second and third capacitors from said ratios in accordance with the relationship:

$$\frac{C}{C_x} = \left.\left(\left.\frac{\partial V_G}{\partial V_d}\right|_{9on} - \left.\frac{\partial V_G}{\partial V_d}\right|_{10on}\right)\right|_{Ids-sat}$$

where $C_x = (C_{x1}^{-1} + C_{x2}^{-1})^{-1}$ and $9_{on}$ represents the condition of the switch means where the second terminal of the first capacitor C is connected to the second terminal of said second capacitor $C_{x1}$ and $10_{on}$ represents the condition of the switch means where the second terminal of the first capacitor C is connected to said gate (5).

In a still further aspect the invention provides a method of measuring capacitance with a capacitance measuring circuit, characterized in that it comprises coupling charge between the drain and gate of a MOS device with a first capacitor C, isolating the gate region of the MOS device from exterior biasing with a second capacitor $C_x$, one of said first and second capacitors having an unknown capacitance and the other having a known capacitance, causing a saturation current to flow between the drain and source of the MOS device, and measuring the ratio $\delta V_G / \delta V_d$ at said saturation current, where $V_G$ is the applied gate voltage, and $V_d$ is the measured drain voltage to derive said unknown capacitance therefrom in accordance with the relationship:

$$\frac{C}{C_x} = -\frac{\partial V_G}{\partial V_d}\bigg|_{Ids-sat}$$

where the right hand side of the relationship is the ratio of $-\delta V_G/\delta V_d$ at said saturation current.

In a still further aspect the invention provides a method of measuring capacitance with a measuring circuit comprising a MOS transistor having a source, drain, and gate; a first capacitor C and a second capacitor $C_{x1}$, characterized in that a first terminal of said second capacitor $C_{x1}$ is connected to said gate and a second terminal of said second capacitor $C_{x1}$ is connected to one terminal of a third capacitor $C_{x2}$ whose other terminal is connected to a source of variable gate voltage $V_G$, one of said capacitors being known, a first terminal of said first capacitor C is connected to said drain and a second terminal of said first capacitor C is connected to switch means for selectively connecting said second terminal of said first capacitor C to said gate or the second terminal of said second capacitor $C_{x1}$ so that charge is coupled from said drain onto said gate either through said first capacitor C and said second capacitor $C_{x1}$ or through said first capacitor C alone, a saturation current is caused to flow between said source and drain, and the ratio $\delta V_G/\delta V_d$ is measured at said saturation current, where $V_G$ is the applied gate voltage, and $V_d$ is the measured drain voltage, for each condition of said switch means, and the capacitance of said second and third capacitors is derived from said ratios in accordance with the relationship:

$$\frac{C}{C_x} = \left(\frac{\partial V_G}{\partial V_d}\bigg|_{9on} - \frac{\partial V_G}{\partial V_d}\bigg|_{10on}\right)\bigg|_{Ids-sat}$$

where $C_x = (C_{x1}^{-1} + C_{x2}^{-1})^{-1}$ and $9_{on}$ represents the condition of the switch means where the second terminal of the first capacitor C is connected to the second terminal of said second capacitor $C_{x1}$ and $10_{on}$ represents the condition of the switch means where the second terminal of the first capacitor C is connected to said gate (5).

The invention will now be described in more detail, by way of example only, with reference to the accompanying drawings, in which:-

Figure 1 is a circuit diagram of a first embodiment of the invention; and

Figure 2 is a circuit diagram of a second embodiment of the invention.

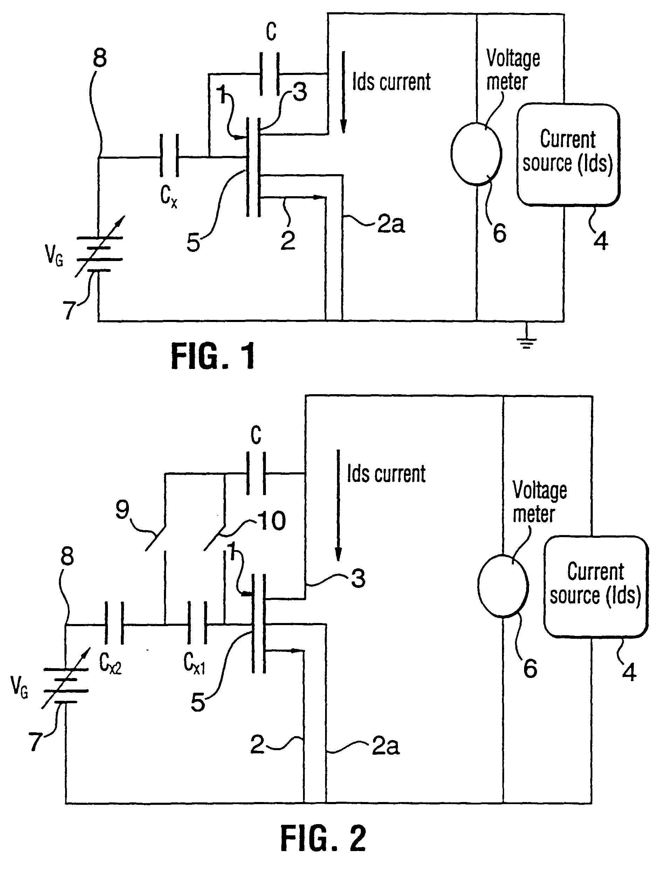

Referring to Figure 1, a n-channel MOSFET 1 has a source 2 and substrate 2a connected to ground, and a drain 3 connected to a constant current supply 4. This current supply 4 supplies a saturation current Ids that flows between the drain 3 and source 2. The drain voltage $V_d$ is measured by a voltage meter 6 connected between the drain 3 and ground.

MOSFET 1 has a gate 5 connected through a capacitor $C_x$ of unknown capacitance to an electrode 8 connected to a source of variable gate voltage $V_G$ 7. A capacitor C connects the drain 3 to the gate 5 so as to couple charge from the drain 3 to the gate 5.

This configuration thus allows the drain to place or couple charge on to the gate of the MOS transistor. The capacitor $C_x$ attached from $V_G$ to the gate is used to isolate the coupling region (i.e. the gate region) from any exterior biasing.

The amount of charge that is coupled is determined by the ratio $C/C_x$. As this ratio increases the amount of coupling also increases. The magnitude of coupling is monitored through the structures current-voltage characteristics.

In order to measure capacitance, the ratio $C_x/C$ is determined by measuring the rate of change of the applied gate voltage $V_G$ with respect to the measured drain voltage when the source drain current Ids is saturated with a suitable measuring device. The unknown capacitance is derived from the relationship

$$\frac{C}{C_x} = -\frac{\partial V_G}{\partial V_d}\bigg|_{Ids-sat}$$

The measurement is performed with the circuit operating in saturation.

In an alternative embodiment, a p-channel device can be used instead of an n-channel device by switching the polarities of all the voltages.

Extra components can be added for stability, obtaining better accuracy, or for integration purposes.

In a second embodiment shown in Figure 2, the device, which is otherwise similar to Figure 1, has two input gate capacitors $Cx_2$ and $Cx_1$ connected in series. Switches 9 and 10 allow the coupling capacitor C to be connected in series selectively either with the series combination of $Cx_2$ and $Cx_1$, or $Cx_2$ alone. In this case, the following relationship holds:

$$\frac{C}{C_x} = \left(\frac{\partial V_G}{\partial V_d}\bigg|_{9on} - \frac{\partial V_G}{\partial V_d}\bigg|_{10on}\right)\bigg|_{Ids-sat}$$

where now $C_x = (C_{x1}^{-1} + C_{x2}^{-1})^{-1}$

This basic mechanism for coupling charge from C to the gate remains the same as described with reference to Figure 1.

This above configuration allows capacitance to be measured without any restrictions on the geometry of the transistor. In the above equation, "on" means the switch is short circuited. It is understood that when one switch is on the other is assumed off.

The invention described can be used for any application in which capacitance measurements are made. Some specific applications include sensing applications based on capacitance measurements, actuator applications based on capacitance monitoring and driving, basic capacitance meters, CV (Capacitive-voltage) meters, and Charge coupling circuits.

**Claims**

1. A capacitance measuring circuit comprising a MOS transistor (1) having a source (2), drain (3), and gate (5); a first capacitor C and a second capacitor $C_x$, characterized in that said first capacitor C is connected across said gate (5) and said drain (3) so that charge is coupled from said drain (3) onto said gate (5), said second capacitor $C_x$ is connected to a source (7) of variable gate voltage $V_G$ and said gate (5), one of said first and second capacitors having a known capacitance and the other of said first and second capacitors having an unknown capacitance which is to be measured, means (4) for applying a saturation current between said source (2) and drain (3); and means (6) for measuring the ratio $\delta V_G/\delta V_d$ at said saturation current, where $V_G$ is the applied gate voltage, and $V_d$ is the measured drain voltage, to derive said unknown capacitance from said ratio in accordance with the relationship:

$$\frac{C}{C_x} = -\frac{\partial V_G}{\partial V_d}\bigg|_{Ids-sat}$$

where the right hand side of the relationship is the ratio of - $\delta V_G/\delta V_d$ at said saturation current.

2. A capacitance measuring circuit as claimed in claim 1, characterized in that said second capacitor $C_x$ has an unknown capacitance.

3. A capacitance measuring circuit comprising a MOS transistor (1) having a source (2), drain (3), and gate (5); a first capacitor C and a second capacitor $C_{x1}$, characterized in that said second capacitor $C_{x1}$ has a first terminal connected to said gate (5) and a second terminal connected to one terminal of a third capacitor $C_{x2}$ whose other terminal is connected to a source (7) of variable gate voltage $V_G$, one of said capacitors being known, said first capacitor C has a first terminal connected to said drain (3) and a second terminal connected to switch means (9,10) for selectively connecting said second terminal of said first capacitor C to said gate (5) or the second terminal of said second capacitor $C_{x1}$ so that charge

is coupled from said drain (3) onto said gate (5) either through said first capacitor C and said second capacitor $C_{x1}$, or through said first capacitor C alone; means (4) for applying a saturation current between said source (2) and drain (3) ; and means (6) for measuring the ratio $\delta V_G/\delta V_d$ at said saturation current, where $V_G$ is the applied gate voltage, and $V_d$ is the measured drain voltage, for each condition of said switch means to derive the capacitance of said second and third capacitors from said ratios in accordance with the relationship:

$$\frac{C}{C_x} = \left( \frac{\partial V_G}{\partial V_d}\bigg|_{9on} - \frac{\partial V_G}{\partial V_d}\bigg|_{10on} \right)\bigg|_{Ids-sat}$$

where $C_x = (C_{x1}^{-1} + C_{x2}^{-1})^{-1}$ and $9_{on}$ represents the condition of the switch means where the second terminal of the first capacitor C is connected to the second terminal of said second capacitor $C_{x1}$ and $10_{on}$ represents the condition of the switch means where the second terminal of the first capacitor C is connected to said gate (5).

4. A capacitance measuring circuit as claimed in claim 1, characterized in that said MOS transistor is an n-channel MOSFET.

5. A capacitance measuring circuit as claimed in claim 1, characterized in that said MOS transistor is a p-channel MOSFET.

6. A method of measuring capacitance with a capacitance measuring circuit, characterized in that it comprises coupling charge between the drain (3) and gate (5) of a MOS device (1) with a first capacitor C, isolating the gate region of the MOS device (1) from exterior biasing with a second capacitor $C_x$, one of said first and second capacitors having an unknown capacitance and the other having a known capacitance, causing a saturation current to flow between the drain (3) and source (2) of the MOS device (1), and measuring the ratio $\delta V_G/\delta V_d$ at said saturation current, where $V_G$ is the applied gate voltage, and $V_d$ is the measured drain voltage to derive said unknown capacitance therefrom in accordance with the relationship:

$$\frac{C}{C_x} = -\frac{\partial V_G}{\partial V_d}\bigg|_{Ids-sat}$$

where the right hand side of the relationship is the ratio of - $\delta V_G/\delta V_d$ at said saturation current.

7. A method of measuring capacitance with a measuring circuit comprising a MOS transistor (1) having a source (2), drain (3), and gate (5); a first capacitor C and a second capacitor $C_{x1}$, characterized in that a first terminal of said second capacitor $C_{x1}$ is connected to said gate (5) and a second terminal of said second capacitor $C_{x1}$ is connected to one terminal of a third capacitor $C_{x2}$ whose other terminal is connected to a source (7) of variable gate voltage $V_G$, one of said capacitors being known, a first terminal of said first capacitor C is connected to said drain (3) and a second terminal of said first capacitor C is connected to switch means (9,10) for selectively connecting said second terminal of said first capacitor C to said gate (5) or the second terminal of said second capacitor $C_{x1}$ so that charge is coupled from said drain (3) onto said gate (5) either through said first capacitor C and said second capacitor $C_{x1}$ or through said first capacitor C alone, a saturation current is caused to flow between said source (2) and drain (3), and the ratio $\delta V_G/\delta V_d$ is measured at said saturation current, where $V_G$ is the applied gate voltage, and $V_d$ is the measured drain voltage, for each condition of said switch means, and the capacitance of said second and third capacitors is derived from said ratios in accordance with the relationship:

$$\frac{C}{C_x} = \left( \left. \frac{\partial V_G}{\partial V_d} \right|_{9on} - \left. \frac{\partial V_G}{\partial V_d} \right|_{10on} \right) \Bigg|_{Ids-sat}$$

where $C_x = (C_{x1}^{-1} + C_{x2}^{-1})^{-1}$ and $9_{on}$ represents the condition of the switch means where the second terminal of the first capacitor C is connected to the second terminal of said second capacitor $C_{x1}$ and $10_{on}$ represents the condition of the switch means where the second terminal of the first capacitor C is connected to said gate (5).

**Patentansprüche**

1. Schaltung zur Messung der Kapazität, bestehend aus einem MOS-Transistor (1) mit einer Quelle (2), einem Drain (3), und einem Gate (5); einem ersten Kondensator C und einem zweiten Kondensator $C_x$, dadurch gekennzeichnet, daß der erste Kondensator C durch das Gate (5) und das Drain (3) angeschlossen ist, so daß die Ladung vom Drain (3) mit dem Gate (5) verbunden ist, daß der zweite Kondensator $C_x$ an eine Quelle (7) mit einer variablen Gate-Spannung $V_G$ und an das Gate (5) angeschlossen ist, wobei einer der ersten und zweiten Kondensatoren eine bekannte Kapazität hat und der andere dieser ersten und zweiten Kondensatoren eine zu messende unbekannte Kapazität hat, Mittel (4) zur Hervorrufung des Sättigungsstromes zwischen der Quelle (2) und dem Drain (3); und Mittel (6) zur Messung des Verhältnisses $\delta V_G/\delta V_d$ im Sättigungsstrom - wobei $V_G$ die angelegte Gate-Spannung darstellt und $V_d$ die gemessene Drain-Spannung - um die unbekannte Kapazität aus dem Verhältnis entsprechend der folgenden Beziehung abzuleiten:

$$\frac{C}{C_x} = - \left. \frac{\partial V_G}{\partial V_d} \right|_{Ids-sat}$$

wo die rechte Seite der Beziehung das Verhältnis - $\delta V_G/\delta V_d$ im Sättigungsstrom ist.

2. Schaltung zur Messung der Kapazität nach Anspruch 1, dadurch gekennzeichnet, daß der zweite Kondensator $C_x$ eine unbekannte Kapazität hat.

3. Schaltung zur Messung der Kapazität, bestehend aus einem MOS-Transistor (1) mit einer Quelle (2), einem Drain (3), und einem Gate (5); einem ersten Kondensator C und einem zweiten Kondensator $C_{x1}$, dadurch gekennzeichnet, daß der zweite Kondensator $C_{x1}$ die erste Klemme an das Gate (5) angeschlossen hat und eine zweite Klemme an eine Klemme eines dritten Kondensators $C_{x2}$, dessen andere Klemme an eine Quelle (7) angeschlossen ist, deren Gate-Spannung $V_G$ variabel ist, wobei einer dieser Kondensatoren bekannt ist, und der erste Kondensator C seine erste Klemme an das Gate (3) angeschlossen hat, und eine zweite Klemme an Schaltungsmittel (9, 10), die selektiv entweder die zweite Klemme des ersten Kondensators oder die zweite Klemme des zweiten Kondensators an das Gate (5) anschliessen können, so daß die Ladung vom Drain (3) mit dem Gate (5) entweder durch den ersten Kondensator C und den zweiten Kondensator $C_{x1}$ oder nur durch den ersten Kondensator C verbunden ist; Mittel (4) zur Hervorrufung des Sättigungsstromes zwischen der Quelle (2) und dem Drain (3); und Mittel (6) zur Messung des Verhältnisses $\delta V_G/\delta V_d$ im Sättigungsstrom - wobei $V_G$ die angelegte Gate-Spannung darstellt und $V_d$ die gemessene Drain-Spannung - um bei jeder der Einstellungen der Schaltungsmittel die unbekannte Kapazität der zweiten und dritten Kondensatoren aus den Verhältnissen entsprechend der folgenden Beziehung abzuleiten:

$$\frac{C}{C_x} = \left( \left. \frac{\partial V_G}{\partial V_d} \right|_{9on} - \left. \frac{\partial V_G}{\partial V_d} \right|_{10on} \right) \Bigg|_{Ids-sat}$$

wo $C_x = (C_{x1}^{-1} + C_{x2}^{-1})^{-1}$ und $9_{on}$ die Einstellung der Schaltungsmittel darstellt, wo die zweite Klemme des ersten Kondensators C an die zweite Klemme des zweiten Kondensators $C_{x1}$ angeschlossen ist und $10_{on}$ die Einstellung der Schaltungsmittel darstellt, wo die zweite Klemme des ersten Kondensators C an das Gate (5) angeschlossen ist.

4. Schaltung zur Messung der Kapazität nach Anspruch 1, dadurch gekennzeichnet, daß der MOS-Transistor ein n-Kanal-MOSFET Transistor ist.

5. Eine Schaltung zur Messung der Kapazität nach Anspruch 1, dadurch gekennzeichnet, daß der MOS-Transistor ein p-Kanal-MOSFET Transistor ist.

6. Verfahren zur Messung der Kapazität mit einer Kapazitätsmeßschaltung, dadurch gekennzeichnet, daß sie die Kopplungsladung zwischen dem Drain (3) und dem Gate (5) einer MOS-Einrichtung (1) mit einem ersten Kondensator C einschließt, wobei die Gate-Region der MOS-Einrichtung (1) vom äußeren Polarisationsstrom mit einem zweiten Kondensator $C_x$ isoliert ist, daß einer der ersten und zweiten Kondensatoren eine unbekannte Kapazität hat, wobei der andere Kondensator eine bekannte Kapazität hat und daß ein Sättigungsstrom zwischen dem Drain (3) und der Quelle (2) der MOS-Einrichtung (1) hervorgerufen wird, nämlich zur Messung des Verhältnisses $\delta V_G/\delta V_d$ im Sättigungsstrom - wobei $V_G$ die angelegte Gate-Spannung darstellt und $V_d$ die gemessene Drain-Spannung - um die unbekannte Kapazität entsprechend der folgenden Beziehung abzuleiten:

$$\frac{C}{C_x} = -\frac{\partial V_G}{\partial V_d}\bigg|_{Ids-sat}$$

wo die rechte Seite der Beziehung das Verhältnis - $\delta V_G/\delta V_d$ im Sättigungsstrom ist.

7. Verfahren zur Messung der Kapazität mit einer Kapazitätsmeßschaltung, bestehend aus einem MOS-Transistor (1) mit einer Quelle (2), einem Drain (3), und einem Gate (5); einem ersten Kondensator C und einem zweiten Kondensator $C_x$, dadurch gekennzeichnet, daß eine erste Klemme des zweiten Kondensators $C_{x1}$ an das Gate (5) angeschlossen ist und eine zweite Klemme des zweiten Kondensators $C_{x1}$ an die Klemme eines dritten Kondensators $C_{x2}$, dessen andere Klemme an eine Quelle (7) mit variabler Gate-Spannung $V_G$ angeschlossen ist, wobei einer dieser Kondensatoren bekannt ist; eine erste Klemme eines ersten Kondensator C an das Drain (3) angeschlossen ist, und eine zweite Klemme dieses ersten Kondensators C an Schaltungsmittel (9, 10) angeschlossen ist, um selektiv entweder die zweite Klemme des ersten Kondensators C oder die zweite Klemme des zweiten Kondensators $C_{x1}$ an das Gate (5) anzuschliessen, so daß die Ladung vom Drain (3) mit dem Gate (5) entweder durch den ersten Kondensator C und den zweiten Kondensator $C_{x1}$ oder nur durch den ersten Kondensator C verbunden ist, daß weiterhin ein Sättigungsstrom zwischen der Quelle (2) und dem Drain (3) hervorgerufen wird; und das Verhältnis $\delta V_G/\delta V_d$ im Sättigungsstrom gemessen wird - wobei $V_G$ die angelegte Gate-Spannung darstellt und $V_d$ die gemessene Drain-Spannung - um bei jeder der Einstellungen der Schaltungsmittel die unbekannten Kapazitäten der zweiten und dritten Kondensatoren aus den Verhältnissen entsprechend der folgenden Beziehung abzuleiten:

$$\frac{C}{C_x} = \left(\frac{\partial V_G}{\partial V_d}\bigg|_{9on} - \frac{\partial V_G}{\partial V_d}\bigg|_{10on}\right)_{Ids-sat}$$

wo $C_x = (C_{x1}^{-1} + C_{x2}^{-1})^{-1}$ und $9_{on}$ die Einstellung der Schaltungsmittel darstellt, wo die zweite Klemme des ersten Kondensators C an die zweite Klemme des zweiten Kondensators $C_{x1}$ angeschlossen ist und $10_{on}$ die Einstellung der Schaltungsmittel darstellt, wo die zweite Klemme des ersten Kondensators C an das Gate (5) angeschlossen ist.

## Revendications

1. Un circuit de mesure de la capacité comprenant un transistor MOS (1) doté d'une source (2), d'un drain (3) et d'une grille (5), d'un premier condensateur C et d'un second condensateur $C_x$, caractérisé en ce que ledit premier condensateur C est relié à travers ladite grille (5) et ledit drain (3) de sorte que la charge est couplée du drain (3) vers ladite grille (5), ledit deuxième condensateur $C_x$ est relié à une source (7) de tension de grille variable $V_G$ et ladite grille (5), un des premiers et deuxièmes condensateurs ayant une capacité connue et l'autre des premiers et deuxièmes condensateurs ayant une capacité inconnue qui doit être mesurée, le moyen (4) pour l'application d'un courant de saturation entre ladite source (2) et le drain (3); et le moyen (6) pour mesurer le rapport $\delta V_G/\delta V_d$ au courant de saturation, où $V_G$ est la tension de grille appliquée, et $V_d$ est la tension de drain mesurée, pour dériver ladite capacité inconnue du rapport conformément à la relation :

$$\frac{C}{C_x} = -\left.\frac{\partial V_G}{\partial V_d}\right|_{Ids-sat}$$

où le côté droit de la relation est le rapport de $-\delta V_G/\delta V_d$ au courant de saturation.

2. Un circuit de mesure de la capacité selon la revendication 1, caractérisé en ce que le deuxième condensateur $C_x$ a une capacité inconnue.

3. Un circuit de mesure de la capacité comprenant un transistor MOS (1) doté d'une source (2), d'un drain (3), et d'une grille (5); un premier condensateur C et un deuxième condensateur $C_{x1}$, caractérisé en ce que ledit deuxième condensateur $C_{x1}$ est doté d'un premier terminal relié à ladite grille (5) et d'un deuxième terminal relié à un terminal d'un troisième condensateur $C_{x2}$, dont l'autre terminal est relié à une source (7) de la tension de grille variable $V_G$; l'un des condensateurs étant connu, ledit premier condensateur C a un premier terminal relié au drain (3) et un deuxième terminal relié à un moyen de commutation (9, 10) afin de connecter sélectivement ledit deuxième terminal du premier condensateur C à ladite grille (5) ou au deuxième terminal du deuxième condensateur $C_{x1}$ de sorte que la charge soit couplée du drain (3) à ladite grille (5), soit à travers le premier condensateur C et le deuxième condensateur $C_{x1}$, ou à travers le premier condensateur C seulement; le moyen (4) pour l'application d'un courant de saturation entre ladite source (2) et le drain (3), et le moyen (6) pour mesurer le rapport $\delta V_G/\delta V_d$ au courant de saturation mentionné, où $V_G$ est la tension de grille appliquée, et $V_d$ est la tension du drain mesurée, pour chaque condition du moyen de commutation afin de dériver la capacité des deuxièmes et troisièmes condensateurs à partir des rapports mentionnés conformément à la relation :

$$\frac{C}{C_x} = \left(\left.\frac{\partial V_G}{\partial V_d}\right|_{9on} - \left.\frac{\partial V_G}{\partial V_d}\right|_{10on}\right)_{Ids-sat}$$

où $C_x = (C_{x1}^{-1} + C_{x2}^{-1})^{-1}$ et $9_{on}$ représente la condition du moyen de commutation où le deuxième terminal du premier condensateur C est relié au deuxième terminal du deuxième condensateur $C_{x1}$, et $10_{on}$ représente la condition du moyen de commutation où le deuxième terminal du premier condensateur C est relié à ladite grille (5).

4. Un circuit de mesure de la capacité selon la revendication 1, caractérisé en ce que ledit transistor MOS est un transistor TECMOS à canal N.

5. Un circuit de mesure de la capacité selon la revendication 1, caractérisé en ce que ledit transistor MOS est un transistor TECMOS à canal P.

6. Une méthode de mesure de la capacité au moyen d'un circuit de mesure de la capacité, caractérisée en ce qu'elle comprend une charge de couplage entre le drain (3) et la grille (5) d'un dispositif MOS (1) doté d'un premier condensateur C, isolant la région de la grille du dispositif MOS (1) de la polarisation extérieure avec un deuxième condensateur $C_x$, un des premiers et deuxièmes condensateurs ayant une capacité inconnue et l'autre ayant une capacité connue, produisant un courant de saturation qui circule entre le drain (3) et la source (2) du dispositif MOS (1), et mesurant le rapport $\delta V_G/\delta V_d$ au courant de saturation, où $V_G$ est la tension de grille appliquée, et $V_d$ est la tension de drain mesurée pour dériver ladite capacité inconnue de cette valeur conformément à la relation suivante :

$$\frac{C}{C_x} = -\left.\frac{\partial V_G}{\partial V_d}\right|_{Ids-sat}$$

où le côté droit de la relation est le rapport de $-\delta V_G/\delta V_d$ au courant de saturation.

7. Une méthode de mesure de la capacité au moyen d'un circuit de mesure comprenant un transistor MOS (1) doté d'une source (2), d'un drain (3), et d'une grille (5); un premier condensateur C et un deuxième condensateur $C_{x1}$, caractérisée en ce qu'un premier terminal du deuxième condensateur $C_{x1}$ est relié à ladite grille (5) et un deuxième terminal du deuxième condensateur $C_{x1}$ est relié à un terminal d'un troisième condensateur $C_{x2}$, dont l'autre terminal est relié à une source (7) de tension de grille variable $V_G$, l'un des condensateurs étant connu; un premier terminal du premier condensateur C est relié au drain (3) et un deuxième terminal du premier condensateur C est relié à un moyen de commutation (9,10) pour relier sélectivement ledit deuxième terminal du premier condensateur C à la grille (5) du deuxième terminal du deuxième condensateur $C_{x1}$ de sorte que la charge est couplée du drain (3) à ladite grille (5) à travers ledit premier condensateur C et ledit deuxième condensateur $C_{x1}$, ou à travers ledit premier condensateur C seulement, un courant de saturation qu'on fait circuler entre ladite source (2) et le drain (3), et le rapport $\delta V_G/\delta V_d$ est mesuré au courant de saturation, où $V_G$ est la tension de grille appliquée, et $V_d$ est la tension de grille mesurée, pour chaque condition du moyen de commutation, et la capacité des deuxièmes et troisièmes condensateurs est dérivée des rapports conformément à la relation suivante :

$$\frac{C}{C_x} = \left( \left. \frac{\partial V_G}{\partial V_d} \right|_{9_{on}} - \left. \frac{\partial V_G}{\partial V_d} \right|_{10_{on}} \right)_{Ids-sat}$$

où $C_x = (C_{x1}^{-1} + C_{x2}^{-1})^{-1}$ et $9_{on}$ représente la condition du moyen de commutation où le deuxième terminal du premier condensateur C est relié au deuxième terminal du deuxième condensateur $C_{x1}$, et $10_{on}$ représente la condition du moyen de commutation où le deuxième terminal du premier condensateur C est relié à ladite grille (5).

**FIG. 1**

**FIG. 2**